# EUROPÄISCHE PATENTANMELDUNG

(11) **EP 1 202 052 A2**
(43) Veröffentlichungstag der Anmeldung: **02.05.2002**
(21) Anmeldenummer: 01125102.2
(22) Anmeldetag: 23.10.2001
(51) Int. Cl.: G01N 27/82, G01R 33/035

(54) **Squid-Mikroskop**

(30) Priorität: 26.10.2000 DE 10053034
(71) Anmelder: FORSCHUNGSZENTRUM JÜLICH GMBH, 52425 Jülich (DE)
(72) Erfinder: Zimmermann, Egon, 52459 Inden (DE); Soltner, Helmut, Dr., 52459 Inden (DE); Glaas, Walter, 50189 Elsdorf (DE); Halling, Horst, Prof. Dr., 52459 Pier (DE); Faley, Mikhail, Dr., 52428 Jülich (DE)

(57) **Zusammenfassung**

Die Erfindung betrifft ein Verfahren zur Messung magnetischer Eigenschaften einer Probe mit einem SQUID, wobei sich Probe und SQUID unter Umgebungsdruck gemeinsam in einer Stickstoffatmosphäre befinden. Dadurch wird einerseits die Kühlung für den SQUID sichergestellt, andererseits verhindert die Stickstoffatmosphäre eine Eisbildung auf der Probe.

Das für dieses Verfahren geeignete erfindungsgemäße SQUID-Mikroskop umfaßt einen nach oben hin offenen Behälter, in dem sich sowohl die SQUID-Halterung mit dem SQUID als auch die Probenhalterung mit der Probe befindet.

Vorteilhaft kann auf einfache Weise durch Einfüllen von flüssigem Stickstoff in den nach oben hin offenen Behälter eine gasförmige Stickstoffatmosphäre eingestellt werden, in der die Probe vermessen werden kann, ohne daß es nachteilig zum Ausfrieren oder Auskondensieren von Wasser auf der Probe kommt. Vorteilhaft können bei dieser Vorrichtung Probe und SQUID nahezu beliebig nahe aneinander geführt werden. Zudem ist ein Probenwechsel besonders einfach zu gestalten.

## Beschreibung

Die Erfindung betrifft ein Mikroskop, insbesondere ein SQUID-Mikroskop zur Untersuchung von magnetischen Eigenschaften einer Probe.

### Stand der Technik

In T. J. Shaw et al., "*High-T*_{*c*} *SQUID microscope study of the effects of microstructure and deformation on the remanent magnetization of steel",* IEEE Transactions on Applied Superconductivity, 1999, (9)2, Seiten 4107 bis 4110, ist ein SQUID-Mikroskop beschrieben. Der SQUID ist auf einem beweglichen Stab angeordnet, wobei sich Stab und SQUID in einem Vakuumraum befinden, der thermisch mit einem flüssigen Stickstoffvorrat gekoppelt ist. Ein Probenhalter mit der Probe ist außerhalb des Vakuumraums angeordnet. Ein Saphirfenster trennt dabei die Probe und den SQUID.
Nachteilig ist, daß die Probe nicht beliebig nahe an den SQUID herangeführt werden kann. Zudem muß für die Messung Vakuum in dem Vakuumraum erzeugt werden.

Aus L. N. Vu et al., "*Design and implementation of a scanning SQUID microscope",* IEEE Transactions on Applied Superconductivity, Bd. 3(1), 1993, Seiten 1918 bis 1921, ist ebenfalls ein SQUID-Mikroskop bekannt. Dieses Mikroskop umfaßt eine Kammer mit flüssigem Helium. Daran angrenzend ist eine durch eine Vakuumzwischenschicht isolierte weitere Probenkammer angeordnet. In dieser befinden sich gemeinsam die Probe und der SQUID, wobei der SQUID auf einem beweglichen Stab angeordnet ist. Der Stab kann in den Probenraum hinein und heraus geführt werden, wobei die Abdichtung nach außen über einen metallischen Blasebalg erfolgt. Probe und SQUID werden durch gasförmiges Helium gekühlt, welches sich in thermischem Kontakt zu dem flüssigen Helium aus der Vorratskammer befindet. Zusätzlich sorgt ein mit flüssigem Stickstoff gekühlter äußerer Zylinder für die Kühlung des Mikroskops.
Bei dieser Anordnung eines SQUID Mikroskops ist das Einsetzen bzw. Wechseln der Probe durch den abgedichteten Probenraum relativ aufwendig und eine Umwälzung des gasförmigen Heliums regelmäßig kostenintensiv.

### Aufgabe und Lösung

Aufgabe der Erfindung ist es, eine einfache Vorrichtung zur Untersuchung von magnetischen Eigenschaften einer Probe mittels eines SQUID-Mikroskops unter Umgebungsdruck zu schaffen, wobei zwischen Probe und SQUID eine nahezu beliebig kleine Distanz einstellbar ist. Ferner ist es die Aufgabe der Erfindung, ein verbessertes Verfahren zur Untersuchung von magnetischen Eigenschaften einer Probe mittels eines SQUID-Mikroskops unter atmosphärischen Bedingungen zu schaffen.

Die Aufgabe wird gelöst durch ein Verfahren gemäß Hauptanspruch sowie durch ein SQUID-Mikroskop gemäß Nebenanspruch. Vorteilhafte Ausführungsformen sind den jeweils darauf rückbezogenen Unteransprüchen zu entnehmen.

### Gegenstand der Erfindung

Bei dem erfindungsgemäßen Verfahren zur Messung magnetischer Eigenschaften einer Probe mit einem SQUID-Mikroskop befinden sich Probe und SQUID in einer Schutzgasatmosphäre. Diese verhindert das Auskondensieren oder Ausfrieren von unerwünschten Komponenten auf der Oberfläche der Probe und/oder des SQUIDs. Da bei dem Verfahren bei Umgebungsdruck gearbeitet wird, kann auf eine aufwendige Vakuumtechnik verzichtet werden. Ein Probenwechsel kann regelmäßig einfach und zeitsparend durchgeführt werden. Die Schutzgasatmosphäre kann unter anderem durch die direkte Verwendung eines Kältebades, bei welchem Kühlmittel verdampft und dann als Schutzgas fungiert, erzeugt werden.

Vorteilhaft bietet sich dabei eine Kühlung des SQUIDs mit flüssigem Stickstoff gemäß Anspruch 2 an. Damit kann auf einfache Weise die Schutzgasatmosphäre direkt aus dem Kühlmittel hergestellt werden.

In einer vorteilhaften Ausgestaltung nach Anspruch 3 wird bei dem erfindungsgemäßen Verfahren ein nach oben hin offener Behälter eingesetzt, in den wenigstens teilweise flüssiger Stickstoff eingefüllt wird.

In einer besonders einfachen Ausführung des Verfahrens werden der SQUID und die Probe so angeordnet, daß sie sich beide in einer Stickstoffatmosphäre befinden, die sich oberhalb von flüssigem Stickstoff ausbildet. Für einen einfachen Probenwechsel bietet es sich an, die Probe oberhalb des SQUIDs anzuordnen.

Das erfindungsgemäße SQUID-Mikroskop nach Anspruch 6 weist einen SQUID, eine SQUID-Halterung und eine Probenhalterung auf. Weiter umfaßt das SQUID-Mikroskop einen nach oben hin offenen Behälter, der der Aufnahme der SQUID-Halterung, des SQUIDs und der Probenhalterung dient. Als ein nach oben hin offener Behälter eignet sich beispielsweise eine einfache Wanne aus Glas, Edelstahl oder auch GFK.

In einer vorteilhaften Ausgestaltung nach Anspruch 7 weist das SQUID-Mikroskop zusätzliche eine Abschirmung aus µ-Metall auf. Dies vermindert äußere magnetische Störungen am SQUID und verbessert so regelmäßig die Genauigkeit der Messungen. Diese Abschirmung kann beispielsweise bis auf eine kleine Öffnung für die Vorrichtung zur Aufnahme der Probe oder des SQUIDs geschlossen werden, um eine optimale Abschirmung zu gewährleisten.

In einer weiteren vorteilhaften Ausgestaltung gemäß Anspruch 8 wird ein Saphirstab als Vorrichtung zur Aufnahme des SQUIDs eingesetzt. In Verbindung mit einem Kältebad dient der Saphirstab als Aufnahmevorrichtung und gleichzeitig als Kälteüberträger. Er weist vorteilhaft eine sehr gute Wärmeleitfähigkeit und eine sehr schlechte elektrische Leitfähigkeit auf.

Eine besonders vorteilhafte Ausführungsform des SQUID-Mikroskops weist zusätzlich eine von der SQUID-Kühlung unabhängige Temperaturregelung für die Probe auf. Damit sind Messungen möglich, bei denen der SQUID und die Probe auf unterschiedlichen Temperaturen gehalten werden können.

In einer weiteren Ausgestaltung nach Anspruch 10 ist die Probenhalterung oberhalb des SQUIDs angeordnet. Es wurde im Rahmen der Erfindung gefunden, daß der Aufbau eines SQUID-Mikroskops, bei dem sich die Probe oberhalb eines gekühlten SQUIDs befindet, erhebliche Vorteile bietet. Bei der Verwendung eines Kältebads kann das Kühlmittel vorteilhaft direkt in den Behälter des SQUID-Mikroskops gefüllt werden. Auf Grund der Verdampfung des flüssigen Kühlmittels, z. B. Stickstoff, bildet sich eine gasförmige Stickstoffatmosphäre oberhalb des flüssigen Stickstoffs. Dieser gasförmige Stickstoff verdrängt die Luft und somit auch die Luftfeuchtigkeit. Dadurch wird auch bei längerem Betrieb verhindert, daß der SQUID, der sich oberhalb des flüssigen Stickstoffs in einer Stickstoffatmosphäre befindet, vereist. Das verdampfte Kühlmittel bildet so gleichzeitig die Schutzgasatmosphäre aus.

Da SQUID und Probe bei dem erfindungsgemäßen SQUID-Mikroskop nicht durch ein Fenster getrennt sind, kann die Probe bis an den SQUID heran geführt werden. Ein Drucksensor oder Kontaktsensor kann vorteilhaft ein Signal bei Kontakt der Probe mit dem SQUID liefern, und so eine exakte Einstellung des Abstands zwischen SQUID und Probe ermöglichen.

Im Rahmen der Erfindung wurde gefunden, daß das erfindungsgemäße SQUID-Mikroskop den Vorteil aufweist, daß die Untersuchungen bei Umgebungsdruck durchgeführt werden können. Dies bedeutet, daß man keine aufwendige Vakuumtechnik einsetzen muß. Während einer Messung verhindert die Schutzgasatmosphäre innerhalb des offenen Behälters ein Auskondensieren von nicht erwünschten Stoffen auf der Probenoberfläche und/oder des SQUIDs. Insbesondere das nachteilige Ausfrieren von Wasser auf der Probenoberfläche kann so verhindert werden.

Das erfindungsgemäße SQUID-Mikroskop weist insgesamt folgende Vorteile auf
- SQUID und Probe können auf atmosphärischem Druck gehalten werden, daher ist keine Vakuumtechnik erforderlich,
- einfacher Zugang zum SQUID oder der Probe beim Aufbau oder während der Messung (z. B. für Qualitätssicherung), d. h. es ist ein schneller Proben- und SQUID-Wechsel möglich,
- es können sehr kleine Abstände (bis 1 µm) zwischen Probe und SQUID eingestellt werden,
- einfache und preiswerte Realisierung der Kühltechnik für HTSL SQUIDs,
- SQUID und Probe können unabhängig gekühlt (bzw. erwärmt) werden.

### Figur und Ausführungsbeispiel

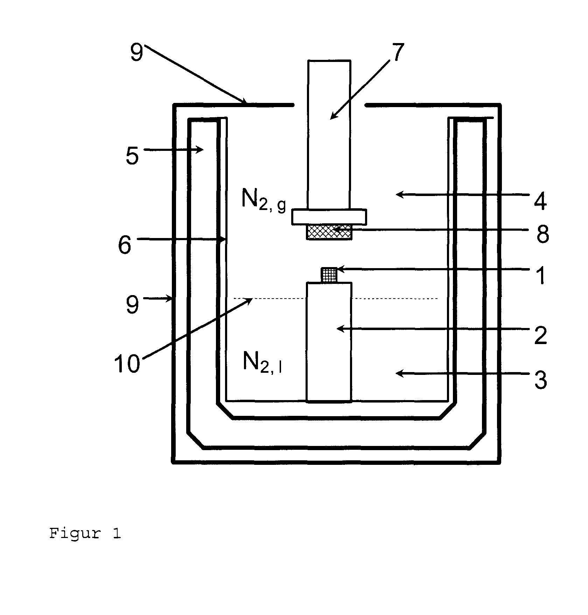

Im weiteren wird die Erfindung anhand einer Figur näher erläutert. Die Figur zeigt schematisch die erfindungsgemäße SQUID-Mikroskop Anordnung.

Abweichend von den bisher bekannten Arten von SQUID-Mikroskopen wird erfindungsgemäß ein vereinfachter Aufbau vorgeschlagen. Der SQUID 1 wird hierbei auf einem Saphirstab 2 befestigt. Der Saphirstab 2 befindet sich teilweise in einem flüssigen Stickstoffbad 3. Er sorgt auf Grund seiner großen Wärmeleitfähigkeit bei 77 K (keine elektrische Leitfähigkeit) für eine hinreichende Kühlung des SQUIDs. Der SQUID selbst befindet sich dabei oberhalb der flüssig/gasförmigen Grenzfläche des Stickstoffs 10.
Auf Grund der Verdampfung des flüssigen Stickstoffs bildet sich eine gasförmige Stickstoffatmosphäre 4 oberhalb des flüssigen Stickstoffs 3. Dieser gasförmige Stickstoff verdrängt die Luft und somit auch die Luftfeuchtigkeit, so daß der SQUID, der sich oberhalb des flüssigen Stickstoffs befindet, auch bei längerem Betrieb nicht vereist.
Als Behälter 5 für den Stickstoff kann ein einfacher Kryostat (z. B. Glaskryostat) verwendet werden.
Der SQUID wird mittels einer Halterung 6 in dem Behälter 5 angeordnet.
Der Probenstab 7 kann mittels einer Scananordnung in x-, y-, z-Richtung bewegt werden, um ein dreidimensionales Abscannen der Magnetfelder der Probe 8 zu ermöglichen.
Vorteilhaft kann ein Drucksensor oder Kontaktsensor bei Kontakt der Probe mit dem SQUID ein Signal liefern, welches zusammen mit einer Scananordnung eine exakte Einstellung des Abstands zwischen SQUID und Probe ermöglicht.
Eine Abschirmung aus µ-Metall 9 vermindert die magnetischen Störungen am SQUID. Diese Abschirmung kann, bis auf eine kleine Öffnung für den Probenstab 7, oberhalb des SQUIDs geschlossen werden, um eine optimale Abschirmung zu gewährleisten.

Legende zur Figur:
1) SQUID
2) Saphirstab
3) Kältebad (Stickstoff)
4) Wasserfreie Atmosphäre durch verdampfenden Stickstoff
5) Kühlmittelbehälter
6) Halterung für SQUID
7) Probenstab
8) Probe
9) Abschirmung aus µ-Metall
10) Füllstandshöhe des flüssigen Stickstoffs

## Patentansprüche

1. Verfahren zur Messung magnetischer Eigenschaften einer Probe mit einem SQUID-Mikroskop, bei dem Probe und SQUID während der Messung gemeinsam in einem Meßraum angeordnet sind,
**dadurch gekennzeichnet,**
**daß** sich Probe und SQUID während der Messung bei Umgebungsdruck in einer Schutzgasatmosphäre befinden.

2. Verfahren nach vorhergehendem Anspruch, bei dem zur Kühlung des SQUIDs flüssiger Stickstoff eingesetzt wird.

3. Verfahren nach vorhergehendem Anspruch, bei dem ein nach oben hin offener Behälter für den flüssigen Stickstoff eingesetzt wird.

4. Verfahren nach einem der vorhergehenden Ansprüche, bei dem der SQUID und die Probe in einer sich über flüssigem Stickstoff ausbildenden, gasförmigen Stickstoffatmosphäre angeordnet werden.

5. Verfahren nach einem der vorhergehenden Ansprüche, bei dem die Probe oberhalb des SQUIDs angeordnet wird.

6. SQUID-Mikroskop, umfassend einen SQUID, eine SQUID-Halterung und eine Probenhalterung zur Aufnahme einer Probe,
**gekennzeichnet durch**
einen nach oben hin offenen Behälter zur Aufnahme der SQUID-Halterung, des SQUIDs und der Probenhalterung.

7. SQUID-Mikroskop nach vorhergehendem Anspruch 6, wobei die Probenhalterung oberhalb der SQUID-Halterung mit dem SQUID angeordnet ist.

8. SQUID-Mikroskop nach einem der vorhergehenden Ansprüche 6 bis 7, mit einem Kühlmedium im Behälter.

9. SQUID-Mikroskop nach einem der vorhergehenden Ansprüche 6 bis 8, mit gasförmigem Stickstoff als Kühlmedium.

10. SQUID-Mikroskop nach einem der vorhergehenden Ansprüche 6 bis 9, bei dem der Behälter zusätzlich flüssigen Stickstoff aufweist.

11. SQUID-Mikroskop nach vorhergehendem Anspruch, bei dem sich die Oberfläche des flüssigen Stickstoffs unterhalb des SQUIDs befindet.

12. SQUID-Mikroskop nach einem der vorhergehenden Ansprüche 6 bis 11, mit einer zusätzlichen Abschirmung aus µ-Metall.

13. SQUID-Mikroskop nach einem der vorhergehenden Ansprüche 6 bis 12, mit einem Saphirstab als SQUID-Halterung.

14. SQUID-Mikroskop nach einem der vorhergehenden Ansprüche 6 bis 13, mit einer von der SQUID-Kühlung unabhängigen Temperaturregelung für die Probe.
